# FASCICULE DE BREVET EUROPEEN

(11) **EP 4 268 287 B1**
(45) Date de publication et mention de la délivrance du brevet: **11.12.2024**
(21) Numéro de dépôt: 21844674.8
(22) Date de dépôt: 22.12.2021
(51) Int. Cl.: H01L 31/115

(54) **DETECTEUR DE PARTICULES COMPRENANT UNE REGION POREUSE REALISEE DANS UN MATERIAU SEMI-CONDUCTEUR ET PROCEDE DE FABRICATION ASSOCIE**
TEILCHENDETEKTOR MIT EINEM PORÖSEN BEREICH AUS HALBLEITERMATERIAL UND ZUGEHÖRIGES HERSTELLUNGSVERFAHREN
PARTICLE DETECTOR COMPRISING A POROUS REGION MADE OF A SEMI-CONDUCTOR MATERIAL, AND ASSOCIATED MANUFACTURING METHOD

(30) Priorité: 23.12.2020 FR 2014090
(43) Date de publication de la demande: 01.11.2023
(73) Titulaire: Universite d'Aix-Marseille, 13007 Marseille (FR); Centre National de la Recherche Scientifique (C.N.R.S.), 75016 Paris (FR); Université de Tours, 37020 Tours Cedex 1 (FR); Insa Centre Val de Loire, 18020 Bourges Cedex (FR)
(72) Inventeur: GAUTIER, Gaël, 37270 Veretz (FR); VERVISCH, Wilfried, 13680 Lançon-Provence (FR); VALENTE, Damien, 37210 Parcay Meslay (FR)
(74) Mandataire: Cabinet Camus Lebkiri
(86) Numéro de dépôt international: PCT/EP2021/087231
(87) Numéro de publication internationale: WO 2022/136516

(56) Documents cités:
- EP-B1- 3 458 878
- FR-A1- 2 742 878
- US-A1- 2015 260 856
- US-A1- 2016 035 913
- US-B1- 9 595 628
- LORIKYAN M P ED - UNNO YOSHINOBU ET AL: "Study of counting characteristics of porous dielectric detectors of radiations", NUCLEAR INSTRUMENTS & METHODS IN PHYSICS RESEARCH. SECTION A, ELSEVIER BV * NORTH-HOLLAND, NL, vol. 515, no. 3, 10 September 2003 (2003-09-10), pages 701 - 717, XP085291856, ISSN: 0168-9002, DOI: 10.1016/J.NIMA.2003.07.029

## Description

### DOMAINE TECHNIQUE DE L'INVENTION

Le domaine technique de l'invention est celui des détecteurs. Plus particulièrement, l'invention concerne un détecteur, détecteur basé sur la technologie dite du semi-conducteur (type diode ou transistor), destiné à mesurer un faisceau de particules.

### ARRIERE-PLAN TECHNOLOGIQUE DE L'INVENTION

Dans les expériences mettant en jeu un faisceau de particules et en particulier un faisceau de particules à hautes énergies, il est nécessaire de mesurer précisément les propriétés du faisceau en minimisant autant que possible son influence sur la mesure. Les technologies de détection habituelles destinées à réaliser la lecture du faisceau sont les chambres d'ionisation, les scintillateurs et la technologie basée sur les composants semi-conducteurs munis d'une jonction à effet redresseur. Il est connu pour mesurer ces faisceaux avec ce type de détection à effet redresseur, d'avoir recours à des détecteurs semi-conducteurs de type Schottky, composée d'une première couche de métal et d'une deuxième couche d'un matériau semi-conducteur ou PIN, composée d'une première couche d'un matériau semi-conducteur dopé p, d'une deuxième couche d'un matériau semi-conducteur intrinsèque et d'une troisième couche d'un matériau semi-conducteur dopé n. Cette structure va donner naissance à une zone active, celle qui permet l'effet redresseur, principalement située dans la couche intrinsèque dans laquelle vont se créer des charges lors du passage du faisceau.

Il est connu de réaliser des contacts métalliques faisant office d'anode et de cathode afin de pouvoir collecter et mesurer ces charges. De manière générale, ces détecteurs sont réalisés dans l'épaisseur d'une plaque de silicium ou autre matériau semi-conducteur et peuvent atteindre une épaisseur sensiblement égale à 300 µm. Ils absorbent donc une quantité non-négligeable de rayonnement. Cette absorption a pour première conséquence de perturber largement le faisceau lors de la mesure. En outre, les interactions rayonnement matière ayant lieu dans un volume important du matériau composant le détecteur, la dégradation des caractéristiques électriques et mécaniques de ce dernier peut être très rapide. Enfin des charges se créent en dehors de la zone active et se diffusent jusqu'aux électrodes ajoutant du bruit au signal de mesure. De plus, l'absorption d'une partie du faisceau dans le matériau, qui conduit donc aux dépôts d'énergie des particules absorbées, est également à l'origine d'une accumulation d'énergie thermique qui peut occasionner, selon le niveau de température, non seulement un dévoiement de la lecture du faisceau mais surtout la destruction du détecteur.

Pour résoudre en partie ce problème d'absorption, il est connu d'amincir la partie du détecteur que le faisceau est amené à traverser lors de la mesure. Cependant, afin de collecter les charges générées par le faisceau, la mise en place d'électrodes sur le trajet du faisceau reste indispensable. La présence de ces électrodes a deux conséquences. Tout d'abord les matériaux utilisés pour la fabrication de ces électrodes absorbent une quantité non-négligeable du faisceau. De plus, la structure du détecteur doit être comprise entièrement entre les électrodes. Or, comme cela a déjà été précisé, la zone active se concentre principalement dans la zone intrinsèque du matériau semi-conducteur. Autrement dit, une grande partie du matériau traversé par le faisceau ne contribue pas directement à la détection.

Afin de pallier ces inconvénients, le brevet EP3458878B1 propose un détecteur dans lequel un orifice a été ménagé dans la partie centrale du détecteur afin de limiter l'absorption du faisceau mesuré. Cependant, un tel orifice fragilise le détecteur ainsi obtenu, ce qui rend la fabrication ou la manipulation de détecteurs de grande taille difficile.

Il existe donc un besoin concernant un détecteur permettant de mesurer un faisceau de particules de hautes énergies possédant une bonne tenue mécanique tout en évitant une absorption excessive dudit faisceau par le détecteur et en limitant la formation de charges non-désirées dans les zones non-active.

### RESUME DE L'INVENTION

L'invention offre une solution aux problèmes évoqués précédemment en fournissant un dispositif de détection dans lequel le faisceau ne traverse que la zone utile du détecteur et une région poreuse. La région poreuse assure ainsi une bonne tenue mécanique du détecteur tout en minimisant la quantité de faisceau absorbée tandis que le reste de la structure permet la collecte des charges générées par le faisceau dans la zone active de manière déportée par rapport au trajet du faisceau à mesurer.

Pour cela, un premier aspect de l'invention concerne un dispositif de mesure d'un faisceau de particules comprenant une face avant et une face arrière ainsi que :
- une première partie, dite partie centrale, comportant des moyens pour former une zone de charge d'espace destinée à être traversée par un faisceau de particules à mesurer, des porteurs de charge d'un premier type et d'un second type étant générés par ledit faisceau lorsque ce dernier traverse la zone de charge d'espace ;
- une deuxième partie, dite partie périphérique, comportant des moyens pour collecter au moins un type de porteur de charge parmi le premier type ou le deuxième type de porteurs de charge générés au niveau de la zone de charge d'espace ;
la partie centrale ayant une épaisseur inférieure ou égale à l'épaisseur de la partie périphérique, la partie périphérique entourant la partie centrale de sorte qu'un faisceau de particule peut traverser la partie centrale sans traverser la partie périphérique.

Le dispositif est caractérisé en ce qu'il comporte, dans une région de la partie centrale et débouchant sur la face arrière, une couche d'un matériau poreux formant une région poreuse de sorte que l'épaisseur effective perçue par le faisceau lorsqu'il traverse le dispositif au niveau de la partie centrale en passant à travers la région poreuse selon un axe normal à la face avant est inférieure à l'épaisseur de la partie centrale, la zone de charge d'espace étant de préférence située en dehors de la région poreuse.

On entend notamment par faisceau de particules, un faisceau de neutrons, de protons, d'électrons ou de photons (par exemple de rayons X, gammas ou UV). Autrement dit, la notion de particules doit être prise ici dans son sens large. On entend par épaisseur effective, l'épaisseur perçue par le faisceau lorsqu'il traverse le milieu poreux. Autrement dit, on pourra dire qu'un matériau poreux a une épaisseur effective *t_{eff}* si l'atténuation du faisceau traversant ce matériau est équivalente à l'atténuation obtenu avec un matériau de même nature mais non poreux d'une épaisseur réelle *t_{eff}.* Il est important de noter que l'épaisseur d'un matériau poreux *tₘₚ* est toujours supérieure à son épaisseur effective *t_{eff},* c'est-à-dire *tₘₚ > t_{eff}.* En effet, la porosité permet de diminuer la quantité de manière présente sur le trajet du faisceau.

Ainsi, le faisceau de particules à mesurer ne traverse que la zone active, c'est-à-dire, la zone de charge d'espace, de préférence située en dehors de la région poreuse, et la région poreuse du détecteur. La perturbation engendrée par le détecteur sur le faisceau est ainsi minimisée sans pour autant remettre en question la bonne tenue mécanique de ce dernier. En outre, la réduction des interactions à la zone active et à la région poreuse permet une diminution substantielle de la température du détecteur liée à ces dernières.

Outre les caractéristiques qui viennent d'être évoquées dans le paragraphe précédent, le dispositif selon un aspect de l'invention peut présenter une ou plusieurs caractéristiques complémentaires parmi les suivantes, considérées individuellement ou selon toutes les combinaisons techniquement possibles.

Dans un mode de réalisation, la partie centrale est réalisée dans un matériau semi-conducteur à large bande interdite (ou grand gap), de préférence du carbure de silicium. On entend par grand gap un gap dont l'énergie est au moins deux fois supérieure à l'énergie du gap du silicium.

Dans un mode de réalisation, la région poreuse est formée à partir d'un matériau semi-conducteur à grand gap.

Dans un mode de réalisation, la zone de charge d'espace est formée à l'aide d'une diode Schottky, d'une diode PN ou d'une diode PIN.

Dans un mode de réalisation, la zone de charge d'espace de la partie centrale est uniquement située dans une région de la partie centrale en regard de région poreuse.

Dans un mode de réalisation, la zone de charge d'espace de la partie centrale s'étend au-delà de la partie centrale en regard de la région poreuse.

Dans un mode de réalisation, la partie centrale comprend :
- une première couche d'un matériau semi-conducteur ;
- une deuxième couche d'un matériau conducteur recouvrant la première couche ;
la zone de charge d'espace étant formée par la diode Schottky formée par la première couche et la deuxième couche, la région poreuse étant formée dans la première couche.

Dans un mode de réalisation, la partie périphérique comprend :
- une troisième couche d'un matériau conducteur ;
- une première couche d'un matériau semi-conducteur recouvrant la troisième couche et disposée en continuité de la première couche de la partie centrale ;
- une deuxième couche d'un matériau conducteur recouvrant la première couche et disposée en continuité de la deuxième couche de la partie centrale ;
la troisième couche d'un matériau conducteur assurant la collecte d'un premier type de porteurs de charge générés dans la zone d'espace de charge.

Dans un mode de réalisation, la partie centrale comprend :
- une première couche d'un matériau semi-conducteur dopé dans un premier type de dopage ;
- une deuxième couche d'un matériau semi-conducteur dopé dans un deuxième type de dopage opposé au premier type de dopage, ladite deuxième couche recouvrant la première couche ;
- une quatrième couche d'un matériau conducteur, ladite quatrième couche recouvrant la deuxième couche ;
la zone de charge d'espace étant formée par la diode PN formée par la première couche et la deuxième couche, la région poreuse étant formée dans la première couche.

Dans un mode de réalisation, la partie périphérique comprend :
- une troisième couche d'un matériau conducteur ;
- une première couche d'un matériau semi-conducteur dopé dans un premier type de dopage recouvrant la troisième couche et disposée en continuité de la première couche de la partie centrale ;
- une deuxième couche d'un matériau semi-conducteur dopé dans un deuxième type de dopage opposé au premier type de dopage recouvrant la première couche, la dite deuxième couche étant disposée en continuité de la deuxième couche de la partie centrale ;
- une quatrième couche d'un matériau conducteur, ladite quatrième couche recouvrant la deuxième couche, la dite quatrième couche étant disposée en continuité de la quatrième couche de la partie centrale ;
la troisième couche d'un matériau conducteur assurant la collecte d'un premier type de porteurs de charge générés dans la zone de charge d'espace.

Dans un mode de réalisation, la partie périphérique comprend :
- une troisième couche d'un matériau conducteur ;
- une première couche d'un matériau semi-conducteur dopé dans un premier type de dopage recouvrant la troisième couche et disposée en continuité de la première couche de la partie centrale, la première couche de la partie centrale et de la partie périphérique ayant le même niveau de dopage ;
- une sixième couche d'un matériau diélectrique (tel qu'un oxyde ou nitrure, verre non dopé, etc.) recouvrant la première couche ;
- une quatrième couche d'un matériau conducteur recouvrant la sixième couche ;
la quatrième couche formant une marche entre la partie périphérique et la partie centrale couvrant une surface latérale de la sixième couche de sorte à assurer une continuité entre la quatrième couche de la partie centrale et la quatrième couche de la partie périphérique, la troisième couche d'un matériau conducteur assurant la collecte d'un premier type de porteurs de charge générés dans la zone d'espace de charge.

Dans un mode de réalisation, la partie centrale comprend :
- une cinquième couche d'un matériau semi-conducteur dopé dans un premier type de dopage, une partie au moins la région poreuse étant formée dans la cinquième couche ;
- une première couche d'un matériau semi-conducteur dopé dans un premier type de dopage, ladite première couche recouvrant la cinquième couche, le niveau de dopage de la cinquième couche étant plus élevé que le niveau de dopage de la couche ;
- une deuxième couche d'un matériau semi-conducteur dopé dans un deuxième type de dopage opposé au premier type de dopage, ladite deuxième couche recouvrant la première couche ;
- une quatrième couche d'un matériau conducteur, ladite quatrième couche recouvrant la deuxième couche ;
la zone de charge d'espace étant formée par la diode PN formée par la cinquième couche, la première couche et la deuxième couche.

Dans un mode de réalisation, la région poreuse est formée sur toute l'épaisseur de la cinquième couche.

Dans un mode de réalisation, une partie de la région poreuse est formée dans la première couche en continuité de la région poreuse formée dans la cinquième couche. Autrement dit, la région poreuse est formée sur toute l'épaisseur de la cinquième couche et une partie de l'épaisseur de la première couche.

Dans un mode de réalisation, la partie périphérique comprend :
- une troisième couche d'un matériau conducteur ;
- une cinquième couche d'un matériau semi-conducteur dopé dans un premier type de dopage recouvrant la troisième couche et disposée en continuité de la cinquième couche de la partie centrale ;
- une première couche d'un matériau semi-conducteur dopé dans un premier type de dopage recouvrant la cinquième couche et disposée en continuité de la première couche de la partie centrale, le niveau de dopage de la cinquième couche étant plus élevé que le niveau de dopage de la première couche ;
- une deuxième couche d'un matériau semi-conducteur dopé dans un deuxième type de dopage opposé au premier type de dopage recouvrant la première couche, la dite deuxième couche étant disposée en continuité de la deuxième couche de la partie centrale ;
- une quatrième couche d'un matériau conducteur, ladite quatrième couche recouvrant la deuxième couche, la dite quatrième couche étant disposée en continuité de la quatrième couche de la partie centrale ;
la troisième couche d'un matériau conducteur assurant la collecte d'un premier type de porteurs de charge générés dans la zone d'espace de charge.

Dans un mode de réalisation, la partie périphérique comporte :
- une troisième couche d'un matériau conducteur ;
- une cinquième couche d'un matériau semi-conducteur dopé dans un premier type de dopage recouvrant la troisième couche et disposée en continuité de la cinquième couche de la partie centrale ;
- une première couche d'un matériau semi-conducteur dopé dans un premier type de dopage recouvrant la cinquième couche et disposée en continuité de la première couche de la partie centrale, la première couche de la partie centrale et de la partie périphérique ayant le même niveau de dopage, le niveau de dopage de la cinquième couche étant plus élevé que le niveau de dopage de la première couche ;
- une sixième couche d'un matériau diélectrique recouvrant la première couche ;
- une quatrième couche d'un matériau conducteur recouvrant la sixième couche ;
la quatrième couche formant une marche entre la partie périphérique et la partie centrale couvrant une surface latérale de la sixième couche de sorte à assurer une continuité entre la quatrième couche de la partie centrale et la quatrième couche de la partie périphérique, la troisième couche d'un matériau conducteur assurant la collecte d'un premier type de porteurs de charge générés dans la zone d'espace de charge.

Un deuxième aspect de l'invention concerne un procédé de fabrication d'un détecteur, à partir d'un substrat semi-conducteur dopé dans un premier type de dopage comprenant une face avant et une face arrière, le procédé de fabrication comprenant ;
- une étape d'épitaxie, sur la face avant du substrat, d'une première couche d'un matériau semi-conducteur intrinsèque ;
- une étape d'épitaxie, sur la face avant du substrat, d'une deuxième couche d'un matériau semi-conducteur dopé dans un deuxième type de dopage opposé au premier type de dopage ;
- une étape de dépôt, sur la face arrière du substrat, d'une troisième couche d'un matériau conducteur ;
- une étape de photolithographie de la troisième couche d'un matériau conducteur de sorte à ménager au moins une première ouverture au sein de ladite couche ;
- une étape de gravure, au niveau de la face arrière de la partie du substrat non recouverte dans la troisième couche conductrice de sorte à former une région poreuse dans le substrat en regard de la première ouverture ;
- une étape de dépôt, sur la face avant du substrat, d'une quatrième couche d'un matériau conducteur.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention et illustrent :
- la [Fig. 1A] une vue de dessus d'un dispositif selon un mode de réalisation de l'invention
- la [Fig. 1B], une vue en coupe d'un dispositif selon un mode de réalisation de l'invention ;
- les [Fig. 2A] et [Fig. 2B], une vue en coupe de la structure du dispositif selon deux variantes d'un premier mode de réalisation ;
- la [Fig. 3], une vue en coupe de la structure du dispositif selon un deuxième mode de réalisation ;
- la [Fig. 4], une vue en coupe de la structure du dispositif selon un troisième mode de réalisation ;
- la [Fig. 5], une vue en coupe de la structure du dispositif selon un quatrième mode de réalisation ;
- la [Fig. 6], une vue en coupe de la structure du dispositif selon un cinquième mode de réalisation ;
- la [Fig. 7], une vue en coupe de la structure du dispositif selon un sixième mode de réalisation ;
- la [Fig. 8], une vue en coupe de la structure du dispositif selon un septième mode de réalisation ;
- La [Fig. 9], un ordinogramme d'un procédé de fabrication selon l'invention
- Les [Fig. 10] à [Fig. 15], les différentes étapes du procédé de fabrication selon l'invention.

### DESCRIPTION DETAILLEE

Les figures sont présentées à titre indicatif et nullement limitatif de l'invention. Dans la suite, le taux de porosité en pourcent fera référence au pourcentage de vide présent dans le matériau considéré.

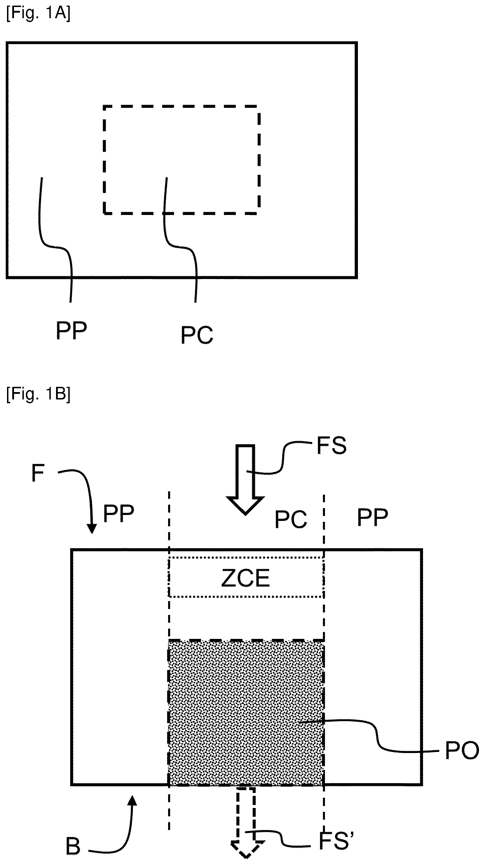

Un aspect de l'invention illustré à la [Fig. 1A] et à la [Fig. 1B] concerne un dispositif de mesure d'un faisceau de particules comprenant une face avant F et une face arrière B.

Le dispositif de mesure comprend également une première partie, dite partie centrale PC (ou bien encore zone de conversion particules/charges électriques), comportant des moyens pour former une zone de charge d'espace ZCE destinée à être traversée par un faisceau de particules FS à mesurer, des porteurs de charge d'un premier type et d'un second type étant générés par ledit faisceau FS lorsque ce dernier traverse la zone de charge d'espace ZCE.

Il comprend également une deuxième partie, dite partie périphérique PP (ou bien encore zone de récolte des charges électriques), comportant des moyens pour collecter au moins un type de porteur de charge parmi le premier type ou le deuxième type de porteurs de charge générés au niveau de la zone de charge d'espace ZCE.

De plus, la partie centrale PC a une épaisseur inférieure ou égale à l'épaisseur la partie périphérique PP, la partie périphérique PP entourant la partie centrale PC de sorte qu'un faisceau de particule FS peut traverser la partie centrale PC sans traverser la partie périphérique PP. Le dispositif selon l'invention comporte en outre, dans une région de la partie centrale et débouchant sur la face arrière B, une couche d'un matériau poreux formant une région poreuse PO de sorte que l'épaisseur effective perçue par le faisceau FS lorsqu'il traverse le dispositif en passant à travers la région poreuse selon un axe normal à la face avant F est inférieure à l'épaisseur de la partie centrale PC.

On entend par épaisseur effective, l'épaisseur perçue par le faisceau lorsqu'il traverse le milieu poreux. Autrement dit, on pourra dire qu'un matériau poreux a une épaisseur effective *t_{eff}* si l'atténuation du faisceau traversant ce matériau est équivalente à l'atténuation obtenue avec un matériau de même nature mais non poreux d'une épaisseur réelle *t_{eff}.* Il est important de noter que l'épaisseur d'un matériau poreux *tₘₚ* est toujours supérieure à son épaisseur effective *t_{eff},* c'est-à-dire *tₘₚ > t_{eff}.*

Ainsi, le dispositif selon l'invention permet de mesurer un faisceau de particules FS en minimisant les perturbations engendrées par la mesure sur le faisceau de sortie FS' tout en garantissant une bonne tenue mécanique du dispositif. Une telle configuration permet notamment de diminuer la quantité de rayonnement absorbé par le dispositif et donc le nombre d'interactions rayonnement matière susceptibles de venir perturber la mesure ou dégrader le dispositif de mesure. En outre, l'utilisation d'un matériau poreux permet d'obtenir une épaisseur effective inférieure à l'épaisseur réellement traversée par le faisceau ce qui permet de minimiser l'absorption tout en conservant une bonne tenue mécanique du détecteur. Cela est particulièrement avantageux dans le cas de détecteurs de grande taille.

La région poreuse peut par exemple être obtenue à l'aide d'un procédé comprenant une étape d'immersion du matériau semi-conducteur dans une solution électrolytique à base d'acide fluorhydrique, puis une étape de polarisation du matériau semi-conducteur de sorte qu'un potentiel est présent entre les deux surfaces du matériau.

Le matériau semi-conducteur cristallin est ainsi gravé de sorte à obtenir une région poreuse. En effet, la polarisation appliquée au matériau semi-conducteur entraine la formation d'un courant qui permet une réaction avec le matériau semi-conducteur et la gravure de ce dernier sous la forme de pores de dimensions variables. Dans un mode de réalisation, les pores ont un diamètre compris entre 1 nm et 100 nm. La durée de la gravure, l'intensité du courant circulant entre les électrodes, la concentration en acide fluorhydrique et des additifs présents dans l'électrolyte sont les principaux paramètres déterminant la taille des pores, la porosité (en d'autres termes, la densité du matériau) et la profondeur de la région poreuse. De manière générale, à concentration d'acide fluorhydrique constante, une augmentation de l'intensité électrique se traduit par un accroissement de la porosité et une augmentation de la durée, par de plus grandes épaisseurs poreuses. Ainsi, une telle méthode de formation d'un matériau poreux permet d'exercer un bon contrôle sur la porosité du matériau, cette dernière étant généralement comprise entre 10 % et 95 %.

Dans un mode de réalisation, la polarisation de la plaquette est assurée par des électrodes situées sur la face de la plaquette sur laquelle l'on souhaite former la partie poreuse. Dans un mode de réalisation alternatif, la polarisation de la plaquette est assurée par des électrodes situées sur la face opposée à la face de la plaquette sur laquelle l'on souhaite former la partie poreuse.

Il est intéressant de noter que, dans le cas particulier du carbure de silicium, les deux faces de la plaquette possèdent des propriétés différentes (face carbone et face silicium). Pour des conditions de gravure identiques, les morphologies de pores obtenues sont alors tout à fait différentes suivant la face de la plaquette gravée.

Pour plus de détails, le lecteur pourra se référer à la thèse de Julie LASCAUD intitulée « Élaboration de couches minces atténuantes en silicium poreux : Application aux transducteurs ultrasonores capacitifs micro-usinés » et soutenue en 2017, et en particulier au chapitre 4.3 relatif à la configuration des cellules électrochimiques ou bien encore G. Gautier, J. Biscarrat, D. Valente, A. Gary and F. Cayrel, Systematic study of anodic etching of highly doped n-type 4H SiC in various HF based electrolytes, J. of Electrochemical society, vol. 160, No 9, pp. D372-D379, 2013 ou G. Gautier, M. Capelle, F. Cayrel, J. Billoué, P. Poveda, X. Song and J-F. Michaud, Room light anodic etching of highly doped n-type 4 H-SiC in high-concentration HF electrolytes: Différence between C and Si crystalline faces, Nanoscale Research Lett., vol. 7, pp. 367-373, 2012.

Dans un mode de réalisation, la région poreuse PO peut être de section circulaire, rectangulaire ou bien encore carré. Plus généralement, elle peut prendre la forme d'un polygone quelconque. La taille de cette région est déterminée par la taille du faisceau à mesurer. De préférence, la largeur du faisceau est inférieure à la largeur de la région poreuse. La largeur de la région centrale peut donc varier du micron à une dizaine de centimètre. De préférence, la totalité de la partie centrale PC est en regard de la région poreuse PO. Autrement dit, les dimensions de de la partie centrale PC sont égales à celle de la section de la région poreuse PO.

De préférence, la partie centrale PC est centrée par rapport à l'ensemble du dispositif. La partie centrale PC, la région poreuse PO et/ou la partie périphérique PP du composant peuvent être réalisées, au moins en partie, dans un matériau semi-conducteur à grand gap, par exemple du carbure de silicium, ou un alliage semi-conducteur composé d'éléments de la colonne III-V ou II-VI. Par exemple, lorsque le semi-conducteur est du carbure de silicium, le dopage p peut être par implantation d'atomes de bore ou d'aluminium et le dopage n par implantation d'atomes d'azote.

De préférence, la zone de charge d'espace ZCE de la partie centrale PC est uniquement située dans une région de la partie centrale PC en regard de la région poreuse. De manière alternative, la zone de charge d'espace ZCE de la partie centrale PC s'étend au-delà de la partie centrale PC en regard de la région poreuse.

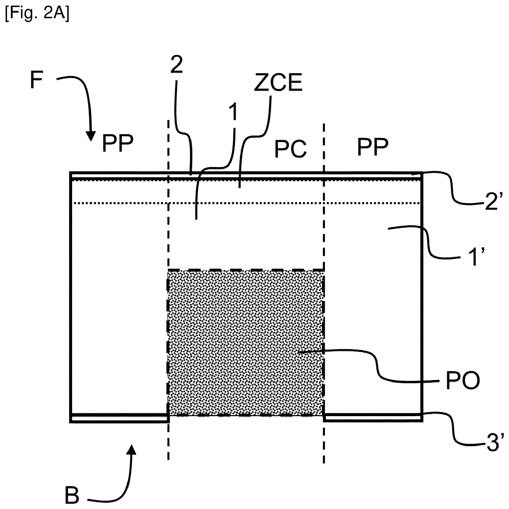

Dans un premier mode de réalisation illustré à la figure 2A, la partie centrale PC comprend une première couche 1 d'un matériau semi-conducteur ; et une deuxième couche 2 d'un matériau conducteur recouvrant la première couche 1. Dans ce mode de réalisation, la zone de charge d'espace ZCE est formée par la diode Schottky formée par la première couche 1 et la deuxième couche 2, la partie poreuse étant formée dans la première couche 1.

De préférence, la région poreuse est comprise entre 1 et 1000 µm. De préférence, le diamètre de la région poreuse est compris entre 1µm et 30 cm.

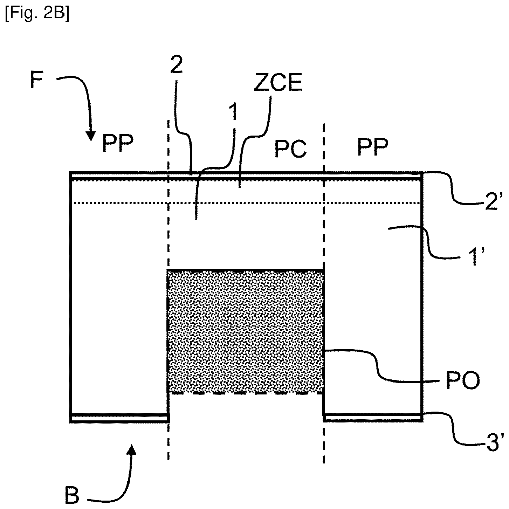

Dans un mode de réalisation illustré à la figure 2B, l'épaisseur de la partie centrale PC est inférieure à l'épaisseur de la partie périphérique PP, laissant ainsi apparaitre un orifice sur la face arrière B au niveau de la région poreuse PO. Dans un mode de réalisation, afin d'obtenir une telle structure, la fabrication de la région poreuse s'effectue en deux phases : durant une première phase un courant très forts courants est appliqué pendant l'anodisation de sorte à réaliser une érosion (autrement dit, toute la matière est retirée) ; durant une deuxième phase, le courant est réduit de sorte à obtenir la région poreuse comme décrit précédemment. Ainsi, il est possible de moduler les épaisseurs de vide et de poreux dans la partie centrale PC du dispositif. Il est utile de noter que cette configuration est également compatible avec les modes de réalisation qui vont être décrit dans la suite. Autrement dit, quel que soit le mode de réalisation, le dispositif de mesure selon l'invention peut comporter un orifice au niveau de région poreuse PO en face arrière B.

De préférence, dans ce mode de réalisation, la partie périphérique PP comprend une troisième couche 3' d'un matériau conducteur ; une première couche 1' d'un matériau semi-conducteur recouvrant la troisième couche 3' et disposée en continuité de la première couche 1 de la partie centrale PC ; et une deuxième couche 2' d'un matériau conducteur recouvrant la première couche 1 et disposée en continuité de la deuxième couche 2 de la partie centrale PC.

Dans cette configuration, appelée configuration Schottky, la zone de charge d'espace ZCE est formée par la diode Schottky constituée par la première couche 1 d'un matériau conducteur et la deuxième couche 2 d'un matériau semi-conducteur. La zone de charge d'espace ZCE se situe donc sur la partie centrale PC mais également sur la partie périphérique PP. En outre, la troisième couche 3' d'un matériau conducteur assure la collecte d'un premier type de porteurs de charge générés dans la zone de charge d'espace de charge ZCE tandis que la première couche 2,2' réalisée dans un matériau conducteur, assure la collecte d'un deuxième type de porteurs de charge générés dans la zone de charge d'espace ZCE. La deuxième couche 2,2' et la troisième couche 3,3' peuvent être constituées par un métal tel que le cuivre, le zinc ou l'or ou bien encore par du graphène mono ou multicouches. On peut également utiliser du nickel, de l'aluminium, du titane ou du tungstène. De manière plus générale, tout matériau conducteur adapté aux conditions de fabrication ou d'opération du dispositif peut être choisi. Le matériau utilisé pour la deuxième couche 2,2' peut être différent du matériau utilisé pour la troisième couche 3,3'. De préférence, les matériaux utilisés pour la troisième couche 3' peuvent être choisis de sorte à obtenir un contact ohmique entre la troisième couche 3' et la première couche 1 ' de la partie périphérique PP.

De préférence, le niveau de dopage de la première couche 1 de la partie centrale PC est identique au niveau de dopage de la première couche 1' de la partie périphérique. Le procédé de fabrication s'en trouve facilité car il ne nécessite qu'un seul niveau de dopage.

De manière alternative, le niveau de dopage de la première couche 1 de la partie centrale PC est inférieur au niveau de dopage de la première couche 1' de la partie périphérique PP. Cette configuration permet de s'assurer une meilleure répartition du champ électrique et donc d'utiliser des tensions plus élevées pour la polarisation du détecteur.

Dans un exemple de réalisation, la première couche 1,1' a une épaisseur comprise entre 500 nm et 50 microns. Dans un mode de réalisation, la deuxième couche 2, 2' a une épaisseur comprise entre 10nm et 200nm, de préférence sensiblement égale à 100nm.

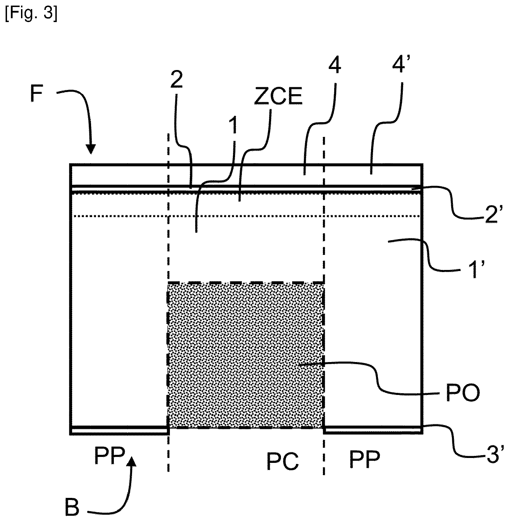

Dans un deuxième mode de réalisation d'un dispositif selon l'invention illustré à la figure 3, la partie centrale PC comprend une première couche 1 d'un matériau semi-conducteur dopé dans un premier type de dopage ; une deuxième couche 2 d'un matériau semi-conducteur dopé dans un deuxième type de dopage opposé au premier type de dopage, ladite deuxième couche 2 recouvrant la première couche 1 ; et une quatrième couche 4 d'un matériau conducteur, ladite quatrième couche 4 recouvrant la deuxième couche 2. Dans ce mode de réalisation, la zone de charge d'espace ZCE est formée par la diode PN formée par la première couche 1 et la deuxième couche 2, la région poreuse étant formée dans la première couche 1.

De préférence, dans ce mode de réalisation, la partie périphérique PP comprend une troisième couche 3' d'un matériau conducteur ; une première couche 1' d'un matériau semi-conducteur dopé dans un premier type de dopage recouvrant la troisième couche 3' et disposée en continuité de la première couche 1 de la partie centrale PC ; une deuxième couche 2' d'un matériau semi-conducteur dopé dans un deuxième type de dopage opposé au premier type de dopage recouvrant la première couche 1', la dite deuxième couche 2' étant disposée en continuité de la deuxième couche 2 de la partie centrale PC ; et une quatrième couche 4' d'un matériau conducteur, ladite quatrième couche 4' recouvrant la deuxième couche 2', la dite quatrième couche 4' étant disposée en continuité de la quatrième couche 4 de la partie PC. Dans un mode de réalisation, le dopage de la première couche 1,1' est de type n et le dopage de la deuxième couche 2,2' est de type p.

Dans cette configuration, appelée configuration PN, la zone de charge d'espace ZCE est formée par la diode PN constituée par la première couche 1,1' d'un matériau semi-conducteur dopé dans un premier type de dopage et la deuxième couche 2,2' d'un matériau semi-conducteur dopé dans un deuxième type de dopage opposé au premier type de dopage. La zone de charge d'espace ZCE se situe donc sur la partie centrale PC mais également sur la partie périphérique PP. En outre, la troisième couche 3' de la partie périphérique assure la collecte d'un premier type de porteurs de charge générés dans la zone de charge d'espace ZCE tandis que la quatrième couche 4,4', réalisée dans un matériau conducteur, assure la collecte d'un deuxième type de porteurs de charge générés dans la zone de charge d'espace ZCE. La troisième couche 3' et la quatrième couche 4,4' peuvent être constituées par un métal tel que le cuivre, le zinc ou l'or ou bien encore par du graphène mono ou multicouches. On peut également utiliser du nickel, de l'aluminium, du titane ou du tungstène. De manière plus générale, tout matériau conducteur adapté aux conditions de fabrication ou d'opération du dispositif peut être choisi. Le matériau utilisé pour la troisième couche 3' peut être différent du matériau utilisé pour la quatrième couche 4,4'. De préférence, les matériaux utilisés pour la troisième couche 3' peuvent être choisis de sorte à obtenir un contact ohmique entre la troisième couche 3' et la première couche 1' de la partie périphérique PP. De même, les matériaux utilisés pour la quatrième couche 4,4' peuvent être choisis de sorte à obtenir un contact ohmique entre la quatrième couche 4,4' et la deuxième couche 2,2'.

De préférence, le niveau de dopage de la première couche 1 de la partie centrale PC est identique au niveau de dopage de la première couche 1' de la partie périphérique PP. De même, le niveau de dopage de la deuxième couche 2 de la partie centrale PC est identique au niveau de dopage de la deuxième couche 2' de la partie périphérique. Comme expliqué précédemment, le procédé de fabrication s'en trouve facilité car il ne nécessite qu'un seul niveau de dopage.

Dans un exemple de réalisation, le dopage de la première couche 1,1' est de type n et le dopage de la deuxième couche 2,2' est de type p. Le niveau de dopage de la première couche 1,1' est compris entre 5.10¹⁴ et 5.10¹⁹ atomes par cm3, de préférence sensiblement égal à 5.10¹⁵ atomes par cm3. Le niveau de dopage de la deuxième couche 2,2' est compris entre 1.10¹⁶ et 5.10¹⁹ atomes par cm3, de préférence sensiblement égal à 1.10¹⁹ atomes par cm3.

De manière alternative, le niveau de dopage de la première couche 1 de la partie centrale PC est inférieur au niveau de dopage de la première couche 1' de la partie périphérique. De même, le niveau de dopage de la deuxième couche 2 de la partie centrale PC est inférieur au niveau de dopage de la deuxième couche 2' de la partie périphérique. Comme expliqué précédemment, cette configuration permet de s'assurer d'une meilleure répartition du champ électrique, ce qui permet d'utiliser des tensions plus élevées pour la polarisation du détecteur.

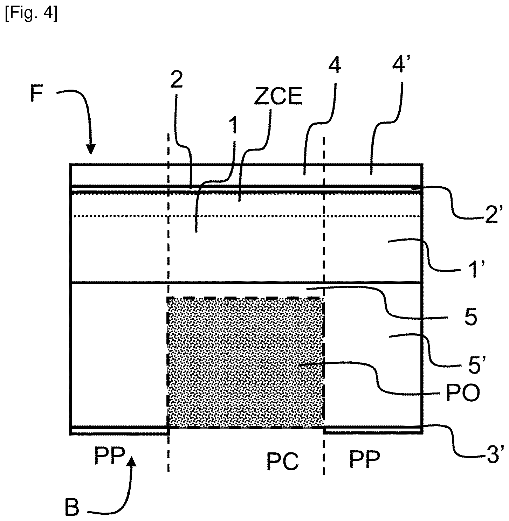

Dans un troisième mode de réalisation illustré à la figure 4, la partie centrale PC comprend une cinquième couche 5 d'un matériau semi-conducteur dopé dans un premier type de dopage, une partie au moins de la région poreuse PO étant formée dans la cinquième couche 5 ; une première couche 1 d'un matériau semi-conducteur dopé dans un premier type de dopage sur la cinquième couche d'un matériau semi-conducteur, le niveau de dopage de la cinquième couche 5 dans la partie centrale PC étant plus élevé que le niveau de dopage de la couche 1 de la partie centrale ; une deuxième couche 2 d'un matériau semi-conducteur dopé dans un deuxième type de dopage opposé au premier type de dopage, ladite deuxième couche 2 recouvrant la première couche 1 ; et une quatrième couche 4 d'un matériau conducteur, ladite quatrième couche 4 recouvrant la deuxième couche 2.

Dans ce mode de réalisation, la partie périphérique PP comporte alors, en plus des couches déjà décrites, une cinquième couche 5' d'un matériau semi-conducteur dopé dans un premier type de dopage disposée en continuité de la cinquième couche 5 de la partie centrale PC, le niveau de dopage de la cinquième couche 5' de la partie périphérique PP étant plus élevé que le niveau de dopage de la première couche 1' de la partie périphérique PP, la cinquième couche 5' étant située entre la troisième couche 3' et la première couche 1' de la partie périphérique PP.

Ainsi dans cette configuration appelée configuration PIN, la diode PIN formée entre la cinquième couche 5,5', la première couche 1,1' et la première couche 2,2' permet une meilleure récupération des charges générées dans la partie centrale PC par le faisceau FS de particules à détecter.

Dans un mode de réalisation, la région poreuse PO est formée sur toute l'épaisseur de la cinquième couche 5 de la partie centrale PC. Dans un mode de réalisation, une partie de la région poreuse PO est formée dans la première couche 1 en continuité de la région poreuse PO formée dans la cinquième 5 couche. Autrement dit, la région poreuse PO est formée sur toute l'épaisseur de la cinquième couche 5 et une partie de l'épaisseur de la première couche 1.

La cinquième couche 5' de la partie périphérique PP peut par exemple être obtenue à partir d'une couche recouvrant la partie centrale PC et la partie périphérique, et dans laquelle une région poreuse a été formée sur une partie seulement de l'épaisseur en laissant une couche au niveau de la partie périphérique correspondant à la cinquième couche 5' de la partie périphérique PP et une couche 5 dans la partie centrale PC de faible épaisseur de sorte à assurer la collecte des charges.

De préférence, le dopage de la première couche 1,1' et de la cinquième couche 5' de la partie périphérique PP est de type n et le dopage de la deuxième couche 2,2' est de type p. Le niveau de dopage de la cinquième couche 5' est compris entre 1.10¹⁶ et 1.10¹⁹ atomes par cm³, de préférence sensiblement égal à 1.10¹⁸ atomes par cm3. Le niveau de dopage de la première couche 1,1' est compris entre 1.10¹¹ et 1.10¹⁷ atomes par cm³, de préférence sensiblement égal à 5.10¹⁵ atomes par cm³. Le niveau de dopage de la deuxième couche 2,2' est compris entre 1.10¹⁶ et 5.10¹⁹ atomes par cm³, de préférence sensiblement égal à 1.10¹⁹ atomes par cm3.

Dans un exemple de réalisation, la première couche 1,1' a une épaisseur comprise entre 500 nm et 50 microns ; la deuxième couche 2 ,2' a une épaisseur comprise entre 50 et 200nm, de préférence sensiblement égale à 100nm ; et la cinquième couche a une épaisseur comprise entre 250 et 350 microns, de préférence sensiblement égale à 300 microns.

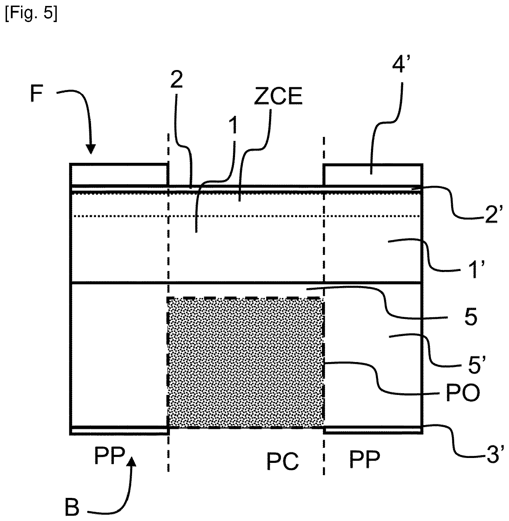

Le faisceau à mesurer ne traversant le détecteur qu'au niveau de la partie centrale PC, il peut être avantageux de déporter la totalité des électrodes nécessaires à la récupération des porteurs de charge au niveau de la partie périphérique. Pour cela, dans un quatrième mode de réalisation illustré à la figure 5, la partie centrale PC comprend une première couche 1 d'un matériau semi-conducteur dopé dans un premier type de dopage et une deuxième couche 2 d'un matériau semi-conducteur dopé dans un deuxième type de dopage opposé au premier type de dopage, ladite deuxième couche 2 recouvrant la première couche 1. La partie centrale est donc dépourvue dans ce mode de réalisation d'électrode. Dans ce mode de réalisation, la zone de charge d'espace est également produite par la diode PN constituée par la première couche 1,1' d'un matériau semi-conducteur dopé dans un premier type de dopage et la deuxième couche 2,2' d'un matériau semi-conducteur dopé dans un deuxième type de dopage opposé au premier type de dopage. En revanche, les porteurs de charges sont récupérés uniquement au niveau de la partie périphérique par les troisième couche 3' et quatrième couche 4' de la partie périphérique PP. Dans cette configuration, le faisceau ne traverse que la première couche 1 et la deuxième couche 2 de la partie centrale au niveau de laquelle se forme la zone d'espace de charge. Dans ce mode de réalisation, la quatrième couche 4' ne se trouve que sur la partie périphérique et forme donc un orifice O1.

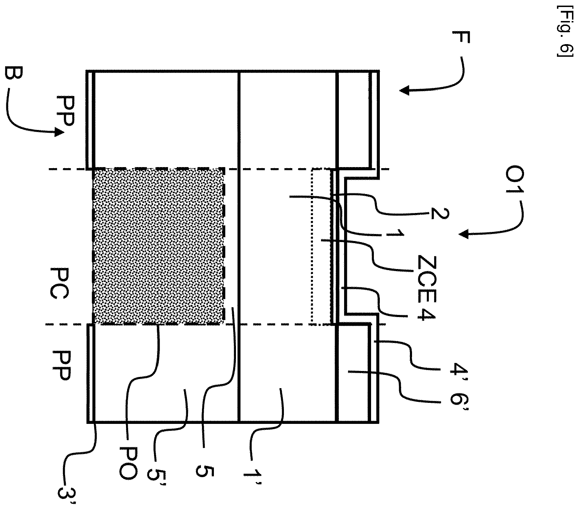

Dans le mode de réalisation précédent, la zone de charge d'espace ZCE est présente à la fois dans la partie centrale PC et la partie périphérique PP du dispositif. Cependant, il peut être avantageux de n'avoir une zone de charge d'espace ZCE que dans la partie centrale PC du dispositif de détection. Pour cela, dans un cinquième mode de réalisation illustré à la figure 6, la partie périphérique PP comprend une troisième couche 3' d'un matériau conducteur ; une première couche 1' d'un matériau semi-conducteur dopé dans un premier type de dopage recouvrant la troisième couche 3' et disposée en continuité de la première couche 1 de la partie centrale PC ; une sixième couche 6' d'un matériau diélectrique recouvrant la première couche 1' ; et une quatrième couche 4' d'un matériau conducteur recouvrant la sixième couche 6'. Ainsi, la couche deuxième 2,2' n'étant présente que dans la partie centrale PC du dispositif, la zone de charge d'espace ZCE se trouve également restreinte à la partie centrale PC du dispositif.

Dans ce mode de réalisation, la quatrième couche 4, 4' forme une marche entre la partie périphérique PP et la partie centrale PC couvrant une surface latérale de la sixième couche 6' de sorte à assurer une continuité entre la quatrième couche 4 de la partie centrale PC et la quatrième couche 4' de la partie périphérique PP. Dans ce mode de réalisation, la sixième couche 6' ne se trouve que sur la partie périphérique et forme donc un orifice O1.

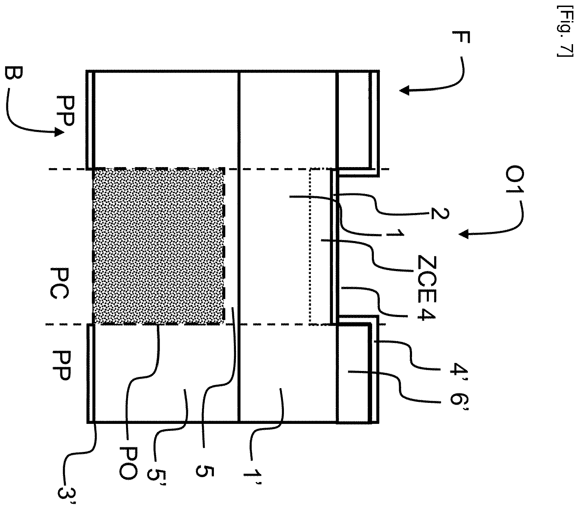

Cependant, dans le mode de réalisation précédent, la quatrième couche 4' de la partie centrale PC recouvre l'intégralité de la partie centrale PC par laquelle passe le faisceau à mesurer. Il peut être avantageux dans certaines situations de diminuer ce phénomène d'absorption. A cette fin, dans un sixième mode de réalisation illustré à la figure 7, la quatrième couche 4' de la partie centrale ne recouvre qu'une partie seulement de la partie centrale PC.

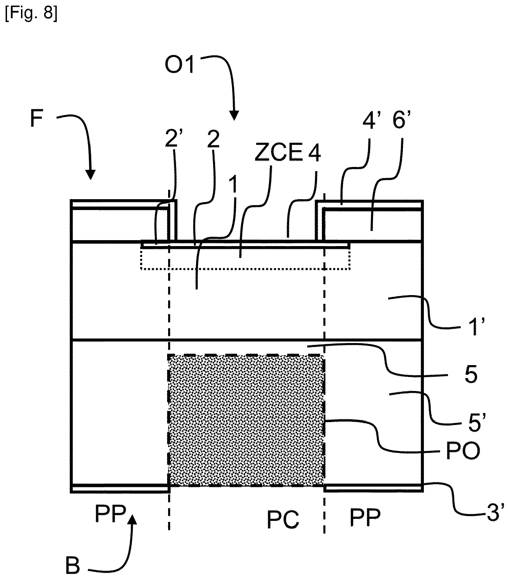

Par ailleurs, lorsque l'étendue de la deuxième couche 2,2' est limitée à la partie centrale PC, la structure MIS (Métal Isolant Semi-Conducteur) constituée au niveau de la partie périphérique PP du dispositif formé par la première couche de la partie périphérique 1', la sixième couche de la partie périphérique 6' et par la quatrième couche 4' de la partie périphérique peut venir perturber la mesure en induisant notamment des effets capacitifs. Afin de prévenir ce phénomène, dans un septième mode de réalisation illustré à la figure 8, la deuxième couche 2' de la partie périphérique ne couvre que partiellement la première couche 1' de la partie périphérique tout en assurant une continuité avec la deuxième couche 2 de la partie centrale PC. Autrement dit, la deuxième couche 2,2' est présente dans toute la partie centrale PC du dispositif ainsi que dans une zone de la partie périphérique PP. La présence de la deuxième couche 2' sur une zone plus étendue que la partie centrale PC limite la formation de la structure MIS précédemment évoquée. On réduit ainsi les phénomènes capacitifs entre la première couche de la partie périphérique 1', la sixième couche de la partie périphérique 6' et par la quatrième couche 4' de la partie périphérique.

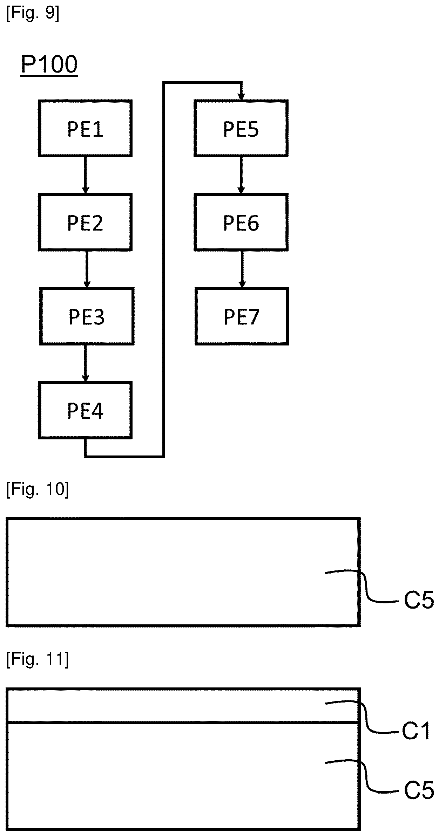

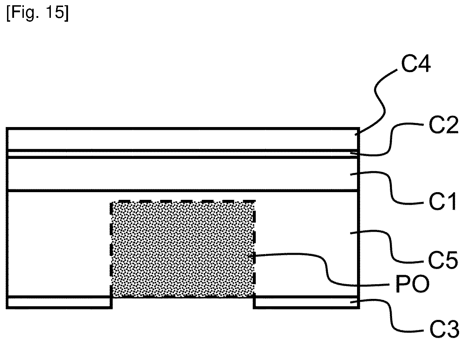

Afin d'obtenir un dispositif selon un premier aspect de l'invention, un deuxième aspect de l'invention illustré aux [Fig. 9] à [Fig. 15] concerne un procédé P100 de fabrication. Comme illustré à la [Fig. 10], cette fabrication se fait à partir d'un substrat C5 ayant un dopage d'un premier type, par exemple le type n. Le substrat est destiné à former la cinquième couche 5,5' de la partie centrale PC et de la partie périphérique PP du dispositif selon un premier aspect de l'invention. De préférence, le substrat C5 est un substrat de type SiC-4H dopé de type n, le niveau de dopage étant de préférence compris entre 5.10¹⁷ et 5.10¹⁸ at.cm⁻³, par exemple égal à 10¹⁸ at.cm⁻³. De préférence, ce dopage est un dopage d'atomes d'azote.

Comme illustré à la [Fig. 11], le procédé P100 selon un deuxième aspect de l'invention comprend une étape PE1 d'épitaxie, sur la face avant du substrat C5, d'une première couche C1 d'un matériau semi-conducteur intrinsèque. Autrement dit, aucune étape de dopage n'est effectuée sur cette couche C1. Cette première couche C1 est destinée à former la première couche 1,1' de la partie centrale PC et de la partie périphérique PP du dispositif.

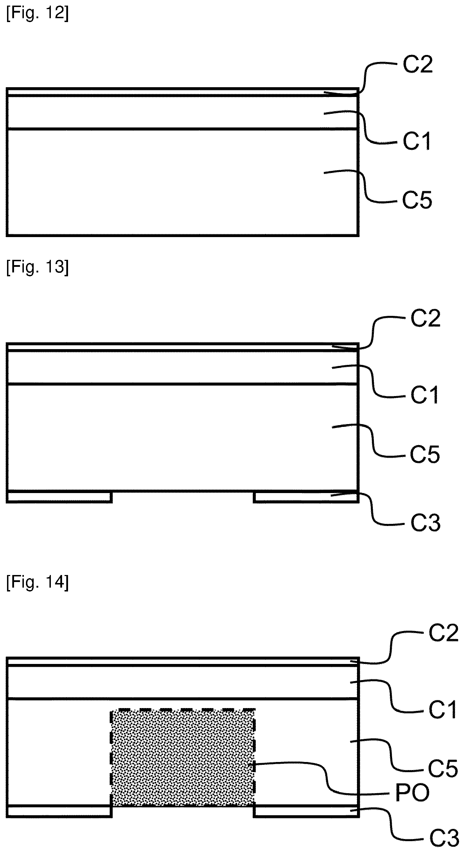

Comme illustré à la [Fig. 12], le procédé P100 comprend ensuite une étape PE2 d'épitaxie, sur la face avant du substrat C5, d'une deuxième couche C2 d'un matériau semi-conducteur dopé dans un deuxième type de dopage opposé au premier type de dopage, par exemple un dopage de type p. De préférence, le dopage de la deuxième couche C2 est compris entre 5.10¹⁷ et 5.10¹⁸ at.cm⁻³, par exemple égal à 10¹⁸ at.cm⁻³. De préférence, ce dopage est un dopage d'atomes d'aluminium. Cette deuxième couche C2 est destinée à former la deuxième couche 2,2' de la partie centrale PC et de la partie périphérique PP du dispositif.

Le procédé P100 comprend ensuite une étape PE3 de dépôt, sur la face arrière du substrat C5, d'une troisième couche C3 d'un matériau conducteur, par exemple une couche de titane ou d'aluminium. Cette troisième couche C3 est destinée à former la troisième couche 3' de la partie périphérique du dispositif. Le procédé comprend également une étape PE4 de photolithographie de la troisième couche C3 d'un matériau conducteur de sorte à ménager au moins une première ouverture au sein de ladite couche C3. La structure obtenue à l'issue de ces deux étapes PE3,PE4 est illustré à la [Fig. 13].

Comme illustré à la [Fig. 14], le procédé P100 comprend également une étape PE5 de gravure, au niveau de la face arrière de la partie du substrat C5 non recouverte dans la troisième couche C3 conductrice de sorte à former une région poreuse PO dans le substrat C5 en regard de la première ouverture.

Dans un mode de réalisation, le substrat C5 est un substrat en SiC. Dans ce mode de réalisation, l'étape PE5 de gravure est mise en oeuvre à l'aide d'une solution à base d'acide fluorhydrique et d'éthanol ayant une concentration comprise entre 5 et 30% en volume (autrement dit, le ratio volumique entre l'acide fluorhydrique et l'éthanol varie entre 5 et 30% en volume total de la solution). Dans un mode de réalisation, l'étape PE5 de gravure est effectuée par l'application d'un courant d'électrolyse dont la densité de courant est comprise entre 10 mA/cm² à 80 mA/cm² pendant une durée d'environ 15 à 120 minutes. Dans un mode de réalisation, la densité de courant est ajustée en cours de gravure de sorte à obtenir une région poreuse PO présentant un degré de porosité variable en fonction de la profondeur de la région poreuse PO. Pour tout détail complémentaire relatif à cette étape PE5 de gravure, le lecteur pourra se référer à la thèse de Julie LASCAUD intitulée « Élaboration de couches minces atténuantes en silicium poreux : Application aux transducteurs ultrasonores capacitifs micro-usinés » déjà citée.

Comme illustré à la [Fig. 15], le procédé P100 comprend une étape PE6 de dépôt, sur la face avant du substrat C5, d'une quatrième couche C4 d'un matériau conducteur, par exemple une couche de titane ou d'aluminium. Cette quatrième couche C4 est destinée à former la quatrième couche 4,4' de la partie centrale PC et de la partie périphérique PP du dispositif.

Dans un mode de réalisation, l'étape PE6 de dépôt est précédée d'une étape de dépôt d'une couche de passivation sur la face avant du substrat C5 et une étape de lithographie de sorte à définir la ou les régions dans lesquelles sera déposée la quatrième couche C4 d'un matériau conducteur. Cette couche de passivation est destinée à former la sixième couche 6' de la partie périphérique du dispositif, la ou les régions ouvertes lors de l'étape de lithographie correspondant alors à la partie périphérique PP du dispositif. Dans un mode de réalisation, la couche de passivation est obtenue par le dépôt d'un oxyde.

## Revendications

1. Dispositif de mesure d'un faisceau de particules comprenant une face avant (F) et une face arrière (B) ainsi que :
- une première partie, dite partie centrale (PC), comportant des moyens pour former une zone de charge d'espace (ZCE) destinée à être traversée par un faisceau de particules (FS) à mesurer, des porteurs de charge d'un premier type et d'un second type étant générés par ledit faisceau (FS) lorsque ce dernier traverse la zone de charge d'espace (ZCE) ;
- une deuxième partie, dite partie périphérique (PP), comportant des moyens pour collecter au moins un type de porteur de charge parmi le premier type ou le deuxième type de porteurs de charge générés au niveau de la zone de charge d'espace (ZCE) ;
la partie centrale (PC) ayant une épaisseur inférieure ou égale à l'épaisseur la partie périphérique (PP), la partie périphérique (PP) entourant la partie centrale (PC) de sorte qu'un faisceau de particule (FS) peut traverser la partie centrale (PC) sans traverser la partie périphérique (PP), le dispositif étant **caractérisé en ce qu'**il comporte, dans une région de la partie centrale et débouchant sur la face arrière (B), une couche d'un matériau poreux formant une région poreuse (PO) de sorte que l'épaisseur effective perçue par le faisceau lorsqu'il traverse le dispositif au niveau de la partie centrale (PC) en passant à travers la région poreuse selon un axe normal à la face avant (F) est inférieure à l'épaisseur de la partie centrale (PC), la zone de charge d'espace (ZCE) étant située en dehors de la région poreuse.

2. Dispositif de mesure selon la revendication précédente **caractérisé en ce que** la partie centrale (PC) est réalisée dans un matériau semi-conducteur à grand gap.

3. Dispositif de mesure selon la revendication précédente **caractérisé en ce que** le semi-conducteur est le carbure de silicium.

4. Dispositif de mesure selon l'une des revendications précédentes **caractérisé en ce que** la zone de charge d'espace (ZCE) est formée à l'aide d'une diode Schottky, une diode PN ou une diode PIN.

5. Dispositif de mesure selon l'une des revendications précédentes **caractérisé en ce que** la zone de charge d'espace (ZCE) de la partie centrale (PC) est uniquement située dans une région de la partie centrale (PC) en regard de région poreuse (PO).

6. Dispositif de mesure selon l'une des revendications 1 à 4 **caractérisé en ce que** la zone de charge d'espace (ZCE) de la partie centrale (PC) s'étend au-delà de la partie centrale (PC) en regard de la région poreuse (PO).

7. Dispositif de mesure selon l'une des revendications 1 à 4 **caractérisé en ce que** la partie centrale (PC) comprend :
- une première couche (1) d'un matériau semi-conducteur ;
- une deuxième couche (2) d'un matériau conducteur recouvrant la première couche (1) ;
la zone de charge d'espace (ZCE) étant formée par la diode Schottky formée par la première couche (1) et la deuxième couche (2), la région poreuse (PO) étant formée dans la première couche (1).

8. Dispositif de mesure selon la revendication précédente **caractérisé en ce que** la partie périphérique (PP) comprend :
- une troisième couche (3') d'un matériau conducteur ;
- une première couche (1') d'un matériau semi-conducteur recouvrant la troisième couche (3') et disposée en continuité de la première couche (1) de la partie centrale (PC) ;
- une deuxième couche (2') d'un matériau conducteur recouvrant la première couche (1) et disposée en continuité de la deuxième couche (2) de la partie centrale (PC) ;
la troisième couche (3') d'un matériau conducteur assurant la collecte d'un premier type de porteurs de charge générés dans la zone d'espace de charge (ZCE).

9. Dispositif de mesure selon la revendication 5 **caractérisé en ce que** la partie centrale (PC) comprend :
- une première couche (1) d'un matériau semi-conducteur dopé dans un premier type de dopage ;
- une deuxième couche (2) d'un matériau semi-conducteur dopé dans un deuxième type de dopage opposé au premier type de dopage, ladite deuxième couche (2) recouvrant la première couche (1) ;
- une quatrième couche (4) d'un matériau conducteur, ladite quatrième couche (4) recouvrant la deuxième couche (2) ;
la zone de charge d'espace (ZCE) étant formée par la diode PN formée par la première couche (1) et la deuxième couche (2), la région poreuse (PO) étant formée dans la première couche (1).

10. Dispositif de mesure selon la revendication précédente **caractérisé en ce que** la partie périphérique (PP) comprend :
- une troisième couche (3') d'un matériau conducteur ;
- une première couche (1') d'un matériau semi-conducteur dopé dans un premier type de dopage recouvrant la troisième couche (3') et disposée en continuité de la première couche (1) de la partie centrale (PC) ;
- une deuxième couche (2') d'un matériau semi-conducteur dopé dans un deuxième type de dopage opposé au premier type de dopage recouvrant la première couche (1'), la dite deuxième couche (2') étant disposée en continuité de la deuxième couche (2) de la partie centrale (PC) ;
- une quatrième couche (4') d'un matériau conducteur, ladite quatrième couche (4') recouvrant la deuxième couche (2'), la dite quatrième couche (4') étant disposée en continuité de la quatrième couche (4) de la partie centrale (PC) ;
la troisième couche (3') d'un matériau conducteur assurant la collecte d'un premier type de porteurs de charge générés dans la zone d'espace de charge (ZCE).

11. Dispositif de mesure selon la revendication 9 **caractérisé en ce que** la partie périphérique (PP) comprend :
- une troisième couche (3') d'un matériau conducteur ;
- une première couche (1') d'un matériau semi-conducteur dopé dans un premier type de dopage recouvrant la troisième couche (3') et disposée en continuité de la première couche (1) de la partie centrale (PC), la première couche (1) de la partie centrale (PC) et de la partie périphérique (PP) ayant le même niveau de dopage ;
- une sixième couche (6) d'un matériau diélectrique recouvrant la première couche (1) ;
- une quatrième couche (4') d'un matériau conducteur recouvrant la sixième couche (6) ;
la quatrième couche (4, 4') formant une marche entre la partie périphérique (PP) et la partie centrale (PC) couvrant une surface latérale de la sixième couche (6') de sorte à assurer une continuité entre la quatrième couche (4) de la partie centrale (PC) et la quatrième couche (4') de la partie périphérique (PP), la troisième couche (3') d'un matériau conducteur assurant la collecte d'un premier type de porteurs de charge générés dans la zone d'espace de charge (ZCE).

12. Dispositif selon la revendication 5 **caractérisé en ce que** la partie centrale (PC) comprend :
- une cinquième couche (5) d'un matériau semi-conducteur dopé dans un premier type de dopage, une partie au moins la région poreuse (PO) étant formée dans la cinquième couche (5) ;
- une première couche (1) d'un matériau semi-conducteur dopé dans un premier type de dopage, ladite première couche (1) recouvrant la cinquième couche (5), le niveau de dopage de la cinquième couche (5) étant plus élevé que le niveau de dopage de la couche (1) ;
- une deuxième couche (2) d'un matériau semi-conducteur dopé dans un deuxième type de dopage opposé au premier type de dopage, ladite deuxième couche (2) recouvrant la première couche (1) ;
- une quatrième couche (4) d'un matériau conducteur, ladite quatrième couche (4) recouvrant la deuxième couche (2) ;
la zone de charge d'espace (ZCE) étant formée par la diode PIN formée par la cinquième couche (5), la première couche (1) et la deuxième couche (2).

13. Dispositif selon la revendication précédente **caractérisé en ce que** la partie périphérique (PP) comprend :
- une troisième couche (3') d'un matériau conducteur ;
- une cinquième couche (5') d'un matériau semi-conducteur dopé dans un premier type de dopage recouvrant la troisième couche (3') et disposée en continuité de la cinquième couche (5) de la partie centrale (PC) ;
- une première couche (1') d'un matériau semi-conducteur dopé dans un premier type de dopage recouvrant la cinquième couche (5') et disposée en continuité de la première couche (1) de la partie centrale (PC), le niveau de dopage de la cinquième couche (5') étant plus élevé que le niveau de dopage de la première couche (1') ;
- une deuxième couche (2') d'un matériau semi-conducteur dopé dans un deuxième type de dopage opposé au premier type de dopage recouvrant la première couche (1'), la dite deuxième couche (2') étant disposée en continuité de la deuxième couche (2) de la partie centrale (PC) ;
- une quatrième couche (4') d'un matériau conducteur, ladite quatrième couche (4') recouvrant la deuxième couche (2'), la dite quatrième couche (4') étant disposée en continuité de la quatrième couche (4) de la partie centrale (PC) ;
la troisième couche (3') d'un matériau conducteur assurant la collecte d'un premier type de porteurs de charge générés dans la zone d'espace de charge (ZCE).

14. Dispositif selon la revendication 12 **caractérisé en ce que** la partie périphérique (PP) comporte :
- une troisième couche (3') d'un matériau conducteur ;
- une cinquième couche (5') d'un matériau semi-conducteur dopé dans un premier type de dopage recouvrant la troisième couche (3') et disposée en continuité de la cinquième couche (5) de la partie centrale (PC) ;
- une première couche (1') d'un matériau semi-conducteur dopé dans un premier type de dopage recouvrant la cinquième couche (3') et disposée en continuité de la première couche (1) de la partie centrale (PC), la première couche (1) de la partie centrale (PC) et de la partie périphérique (PP) ayant le même niveau de dopage, le niveau de dopage de la cinquième couche (5') étant plus élevé que le niveau de dopage de la première couche (1') ;
- une sixième couche (6) d'un matériau diélectrique recouvrant la première couche (1) ;
- une quatrième couche (4') d'un matériau conducteur recouvrant la sixième couche (6) ;
la quatrième couche (4, 4') formant une marche entre la partie périphérique (PP) et la partie centrale (PC) couvrant une surface latérale de la sixième couche (6') de sorte à assurer une continuité entre la quatrième couche (4) de la partie centrale (PC) et la quatrième couche (4') de la partie périphérique (PP), la troisième couche (3') d'un matériau conducteur assurant la collecte d'un premier type de porteurs de charge générés dans la zone d'espace de charge (ZCE).

15. Procédé (P100) de fabrication d'un détecteur selon l'une des revendications précédentes, à partir d'un substrat (C5) semi-conducteur dopé dans un premier type de dopage comprenant une face avant et une face arrière, le procédé (P100) de fabrication comprenant ;
- une étape (PE1) d'épitaxie, sur la face avant du substrat (C5), d'une première couche (C1) d'un matériau semi-conducteur intrinsèque ;
- une étape (PE2) d'épitaxie, sur la face avant du substrat (C5), d'une deuxième couche (C2) d'un matériau semi-conducteur dopé dans un deuxième type de dopage opposé au premier type de dopage ;
- une étape (PE3) de dépôt, sur la face arrière du substrat, d'une troisième couche (C3) d'un matériau conducteur ;
- une étape (PE4) de photolithographie de la troisième couche (C3) d'un matériau conducteur de sorte à ménager au moins une première ouverture au sein de ladite couche (C3) ;
- une étape (PE5) de gravure, au niveau de la face arrière de la partie du substrat (C5) non recouverte dans la troisième couche (C3) conductrice de sorte à former une région poreuse (PO) dans le substrat (C5) en regard de la première ouverture ;
- une étape (PE6) de dépôt, sur la face avant du substrat (C5), d'une quatrième couche (C4) d'un matériau conducteur.

## Patentansprüche

1. Vorrichtung zur Messung eines Teilchenstrahls mit einer Vorderseite (F) und einer Rückseite (B) sowie:
- einen ersten Teil, den sogenannten zentralen Teil (PC), mit Mitteln zur Bildung einer Raumladungszone (ZCE), die von einem zu messenden Teilchenstrahl (FS) durchquert werden soll, wobei Ladungsträger eines ersten Typs und eines zweiten Typs von dem Strahl (FS) erzeugt werden, wenn dieser die Raumladungszone (ZCE) durchläuft;
- einen zweiten Teil, den sogenannten peripheren Teil (PP), mit Mitteln zum Sammeln mindestens einer Art von Ladungsträgern aus der ersten Art oder der zweiten Art von Ladungsträgern, die im Bereich der Raumladungszone (RLZ) erzeugt werden;
wobei der zentrale Teil (PC) eine Dicke hat, die kleiner oder gleich der Dicke des peripheren Teils (PP) ist, wobei der periphere Teil (PP) den zentralen Teil (PC) umgibt, so dass ein Teilchenstrahl (FS) den zentralen Teil (PC) durchqueren kann, ohne den peripheren Teil (PP) zu durchqueren, wobei die Vorrichtung **dadurch gekennzeichnet ist, dass** sie in einem Bereich des zentralen Teils, der an der Rückseite (B) mündet, eine Schicht aus einem porösen Material umfasst, die einen porösen Bereich (PO) bildet, sodass die effektive Dicke, die vom Strahl wahrgenommen wird, wenn er die Vorrichtung im Bereich des zentralen Teils (PC) und den porösen Bereich entlang einer Normalachse zur Vorderseite (F) durchquert, kleiner ist als die Dicke des zentralen Teils (PC), wobei sich die Raumladungszone (ZCE) außerhalb des porösen Bereichs befindet.

2. Messvorrichtung nach dem vorhergehenden Anspruch, **dadurch gekennzeichnet, dass** der zentrale Teil (PC) aus einem halbleitenden Material mit weiter Bandlücke hergestellt ist.

3. Messvorrichtung nach dem vorhergehenden Anspruch, **dadurch gekennzeichnet, dass** der Halbleiter Siliziumkarbid ist.

4. Messvorrichtung nach einem der vorhergehenden Ansprüche, **dadurch gekennzeichnet, dass** die Raumladungszone (ZCE) mithilfe einer Schottky-Diode, einer PN-Diode oder einer PIN-Diode gebildet wird.

5. Messvorrichtung nach einem der vorhergehenden Ansprüche, **dadurch gekennzeichnet, dass** die Raumladungszone (ZCE) des zentralen Teils (PC) nur in einem Bereich des zentralen Teils (PC) gegenüber des porösen Bereichs (PO) angeordnet ist.

6. Messvorrichtung nach einem der Ansprüche 1 bis 4, **dadurch gekennzeichnet, dass** sich die Raumladungszone (ZCE) des zentralen Teils (PC) über den zentralen Teil (PC) hinaus gegenüber dem porösen Bereich (PO) erstreckt.

7. Messvorrichtung nach einem der Ansprüche 1 bis 4, **dadurch gekennzeichnet, dass** der zentrale Bereich (PC) umfasst:
- eine erste Schicht (1) aus einem Halbleitermaterial;
- eine zweite Schicht (2) aus einem leitfähigen Material, die die erste Schicht (1) bedeckt;
wobei die Raumladungszone (ZCE) durch die Schottky-Diode gebildet wird, die durch die erste Schicht (1) und die zweite Schicht (2) gebildet wird, wobei der poröse Bereich (PO) in der ersten Schicht (1) gebildet wird.

8. Messvorrichtung nach dem vorhergehenden Anspruch, **dadurch gekennzeichnet, dass** der periphere Teil (PP) umfasst:
- eine dritte Schicht (3') aus einem leitfähigen Material;
- eine erste Schicht (1') aus einem Halbleitermaterial, die die dritte Schicht (3') bedeckt und an die erste Schicht (1) des zentralen Teils (PC) angrenzend angeordnet ist;
- eine zweite Schicht (2') aus einem leitfähigen Material, die die erste Schicht (1) bedeckt und in Fortsetzung der zweiten Schicht (2) des zentralen Teils (PC) angeordnet ist;
wobei die dritte Schicht (3') aus einem leitfähigen Material das Sammeln einer ersten Art von Ladungsträgern gewährleistet, die in der Raumladungszone (ZCE) erzeugt werden.

9. Messvorrichtung nach Anspruch 5, **dadurch gekennzeichnet, dass** der zentrale Teil (PC) umfasst:
- eine erste Schicht (1) aus einem Halbleitermaterial, das in einer ersten Dotierungsart dotiert ist;
- eine zweite Schicht (2) aus einem Halbleitermaterial, das in einer zweiten Dotierungsart dotiert ist, die der ersten Dotierungsart entgegengesetzt ist, wobei diese zweite Schicht (2) die erste Schicht (1) bedeckt;
- eine vierte Schicht (4) aus einem leitfähigen Material, wobei die vierte Schicht (4) die zweite Schicht (2) bedeckt;
wobei die Raumladungszone (ZCE) von der PN-Diode gebildet wird, die von der ersten Schicht (1) und der zweiten Schicht (2) gebildet wird, wobei der poröse Bereich (PO) in der ersten Schicht (1) gebildet ist.

10. Messvorrichtung nach dem vorhergehenden Anspruch, **dadurch gekennzeichnet, dass** der periphere Teil (PP) umfasst:
- eine dritte Schicht (3') aus einem leitfähigen Material;
- eine erste Schicht (1') aus einem Halbleitermaterial, das in einer ersten Dotierungsart dotiert ist, die die dritte Schicht (3') bedeckt und in Kontinuität mit der ersten Schicht (1) des zentralen Teils (PC) angeordnet ist;
- eine zweite Schicht (2') aus einem Halbleitermaterial, das in einer zweiten Dotierungsart dotiert ist, die der ersten Dotierungsart entgegengesetzt ist, die die erste Schicht (1') bedeckt, wobei die zweite Schicht (2') in Kontinuität mit der zweiten Schicht (2) des zentralen Teils (PC) angeordnet ist;
- eine vierte Schicht (4') aus einem leitfähigen Material, wobei die vierte Schicht (4') die zweite Schicht (2') bedeckt, wobei die vierte Schicht (4') in Kontinuität mit der vierten Schicht (4) des zentralen Teils (PC) angeordnet ist;
wobei die dritte Schicht (3') aus einem leitfähigen Material das Sammeln einer ersten Art von Ladungsträgern gewährleistet, die in der Raumladungszone (ZCE) erzeugt werden.

11. Messvorrichtung nach Anspruch 9, **dadurch gekennzeichnet, dass** der periphere Teil (PP) umfasst:
- eine dritte Schicht (3') aus einem leitfähigen Material;
- wobei eine erste Schicht (1') aus einem Halbleitermaterial, das in einer ersten Dotierungsart dotiert ist, die dritte Schicht (3') bedeckt und in Kontinuität mit der ersten Schicht (1) des zentralen Teils (PC) angeordnet ist, wobei die erste Schicht (1) des zentralen Teils (PC) und des peripheren Teils (PP) den gleichen Dotierungsgrad haben;
- wobei eine sechste Schicht (6) aus einem dielektrischen Material die erste Schicht (1) bedeckt;
- wobei eine vierte Schicht (4') aus einem leitfähigen Material die sechste Schicht (6) bedeckt;
wobei die vierte Schicht (4, 4') eine Stufe zwischen dem peripheren Teil (PP) und dem zentralen Teil (PC) bildet und eine Seitenfläche der sechsten Schicht (6') bedeckt, sodass eine Kontinuität zwischen der vierten Schicht (4) des zentralen Teils (PC) und der vierten Schicht (4') des peripheren Teils (PP) gewährleistet ist, wobei die dritte Schicht (3') aus einem leitfähigen Material das Sammeln einer ersten Art von Ladungsträgern, die in der Raumladungszone (ZCE) erzeugt werden, sicherstellt.

12. Vorrichtung nach Anspruch 5, **dadurch gekennzeichnet, dass** der zentrale Teil (PC) umfasst:
- eine fünfte Schicht (5) aus einem Halbleitermaterial, das in einer ersten Dotierungsart dotiert ist, wobei zumindest ein Teil des porösen Bereichs (PO) in der fünften Schicht (5) ausgebildet ist;
- eine erste Schicht (1) aus einem Halbleitermaterial, das in einer ersten Dotierungsart dotiert ist, wobei die erste Schicht (1) die fünfte Schicht (5) bedeckt, wobei der Dotierungsgrad der fünften Schicht (5) höher ist als der Dotierungsgrad der Schicht (1);
- eine zweite Schicht (2) aus einem Halbleitermaterial, das in einer zweiten Dotierungsart dotiert ist, die der ersten Dotierungsart entgegengesetzt ist, wobei die zweite Schicht (2) die erste Schicht (1) bedeckt;
- eine vierte Schicht (4) aus einem leitfähigen Material, wobei die vierte Schicht (4) die zweite Schicht (2) bedeckt;
wobei die Raumladungszone (ZCE) von der PIN-Diode gebildet wird, die von der fünften Schicht (5), der ersten Schicht (1) und der zweiten Schicht (2) gebildet wird.

13. Vorrichtung nach dem vorhergehenden Anspruch, **dadurch gekennzeichnet, dass** der periphere Teil (PP) umfasst:
- eine dritte Schicht (3') aus einem leitfähigen Material;
- eine fünfte Schicht (5') aus einem Halbleitermaterial, das in einer ersten Dotierungsart dotiert ist, die die dritte Schicht (3') bedeckt und in Kontinuität mit der fünften Schicht (5) des zentralen Teils (PC) angeordnet ist;
- eine erste Schicht (1') aus einem Halbleitermaterial, das in einer ersten Dotierungsart dotiert ist, die die fünfte Schicht (5') bedeckt und in Kontinuität mit der ersten Schicht (1) des zentralen Teils (PC) angeordnet ist, wobei der Dotierungsgrad der fünften Schicht (5') höher ist als der Dotierungsgrad der ersten Schicht (1');
- eine zweite Schicht (2') aus einem Halbleitermaterial, das in einer zweiten Dotierungsart dotiert ist, die der ersten Dotierungsart entgegengesetzt ist, und die erste Schicht (1') bedeckt, wobei die zweite Schicht (2') in Kontinuität mit der zweiten Schicht (2) des zentralen Teils (PC) angeordnet ist;
- eine vierte Schicht (4') aus einem leitfähigen Material, wobei die vierte Schicht (4') die zweite Schicht (2') bedeckt, wobei die vierte Schicht (4') in Kontinuität mit der vierten Schicht (4) des zentralen Teils (PC) angeordnet ist;
wobei die dritte Schicht (3') aus einem leitfähigen Material das Sammeln einer ersten Art von Ladungsträgern gewährleistet, die in der Raumladungszone (ZCE) erzeugt werden.

14. Vorrichtung nach Anspruch 12, **dadurch gekennzeichnet, dass** der periphere Teil (PP) umfasst:
- -eine dritte Schicht (3') aus einem leitfähigen Material;
- -eine fünfte Schicht (5') aus einem Halbleitermaterial, das in einer ersten Dotierungsart dotiert ist, die die dritte Schicht (3') bedeckt und in Kontinuität mit der fünften Schicht (5) des zentralen Teils (PC) angeordnet ist;
- -eine erste Schicht (1') aus einem Halbleitermaterial, das in einer ersten Dotierungsart dotiert ist, die die fünfte Schicht (3') bedeckt und in Kontinuität mit der ersten Schicht (1) des zentralen Teils (PC) angeordnet ist, wobei die erste Schicht (1) des zentralen Teils (PC) und des peripheren Teils (PP) den gleichen Dotierungsgrad haben, wobei der Dotierungsgrad der fünften Schicht (5') höher ist als der Dotierungsgrad der ersten Schicht (1');
- eine sechste Schicht (6) aus einem dielektrischen Material, die die erste Schicht (1) bedeckt;
- eine vierte Schicht (4') aus einem leitfähigen Material, die die sechste Schicht (6) bedeckt;
wobei die vierte Schicht (4, 4') eine Stufe zwischen dem peripheren Teil (PP) und dem zentralen Teil (PC) bildet und eine Seitenfläche der sechsten Schicht (6`) bedeckt, sodass eine Kontinuität zwischen der vierten Schicht (4) des zentralen Teils (PC) und der vierten Schicht (4') des peripheren Teils (PP) gewährleistet ist, wobei die dritte Schicht (3') aus einem leitfähigen Material das Sammeln einer ersten Art von Ladungsträgern, die in der Raumladungszone (ZCE) erzeugt werden, sicherstellt.

15. Verfahren (P100) zur Herstellung eines Detektors nach einem der vorhergehenden Ansprüche, ausgehend von einem Halbleitersubstrat (C5), das in einer ersten Dotierungsart dotiert ist und eine Vorderseite und eine Rückseite umfasst, wobei das Herstellungsverfahren (P100) umfasst:
- einen Schritt (PE1) des Epitaxierens einer ersten Schicht (C1) aus einem intrinsischen Halbleitermaterial auf der Vorderseite des Substrats (C5);
- einen Schritt (PE2) des Epitaxierens einer zweiten Schicht (C2) aus einem Halbleitermaterial, das in einer zweiten Dotierungsart dotiert ist, die der ersten Dotierungsart entgegengesetzt ist, auf der Vorderseite des Substrats (C5);
- einen Schritt (PE3) des Aufbringens einer dritten Schicht (C3) aus einem leitfähigen Material auf der Rückseite des Substrats;
- einen Schritt (PE4) des Fotolithographierens der dritten Schicht (C3) aus einem leitfähigen Material, sodass mindestens eine erste Öffnung in der Schicht (C3) gebildet wird;
- einen Schritt (PE5) des Ätzens im Bereich der Rückseite des Teils des Substrats (C5), der in der dritten leitenden Schicht (C3) nicht bedeckt ist, sodass ein poröser Bereich (PO) in dem Substrat (C5) gegenüber der ersten Öffnung gebildet wird;
- einen Schritt (PE6) des Aufbringens einer vierten Schicht (C4) aus einem leitfähigen Material auf die Vorderseite des Substrats (C5).

## Claims

1. A device for measuring a particle beam comprising a front face (F) and a rear face (B) as well as:
- a first part, referred to as the central part (PC), including means for forming a space charge zone (ZCE) for a particle beam (FS) to be measured to pass therethrough, charge carriers of a first type and of a second type being generated by said beam (FS) when the same passes through the space charge zone (ZCE);
- a second part, referred to as the peripheral part (PP), including means for collecting at least one type of charge carrier among the first type or the second type of charge carriers generated at the space charge zone (ZCE);
the central part (PC) having a thickness less than or equal to the thickness of the peripheral part (PP), the peripheral part (PP) surrounding the central part (PC) so that a particle beam (FS) can pass through the central part (PC) without passing through the peripheral part (PP), the device being **characterised in that** it includes, in a region of the central part and opening onto the rear face (B), a layer of a porous material forming a porous region (PO) so that the effective thickness perceived by the beam when it passes through the device at the central part (PC) by passing through the porous region along an axis normal to the front face (F) is less than the thickness of the central part (PC), the space charge zone (ZCE) being situated outside the porous region.

2. The measurement device according to the preceding claim, **characterised in that** the central part (PC) is made of a wide band gap semiconductor material.

3. The measurement device according to the preceding claim, **characterised in that** the semiconductor is silicon carbide.

4. The measurement device according to any of the preceding claims, **characterised in that** the space charge zone (ZCE) is formed by means of a Schottky diode, a PN diode or a PIN diode.

5. The measurement device according to any of the preceding claims, **characterised in that** the space charge zone (ZCE) of the central part (PC) is only located in a region of the central part (PC) facing the porous region (PO).

6. The measurement device according to any of claims 1 to 4, **characterised in that** the space charge zone (ZCE) of the central part (PC) extends beyond the central part (PC) facing the porous region (PO).

7. The measurement device according to any of claims 1 to 4, **characterised in that** the central part (PC) comprises:
- a first layer (1) of a semiconductor material;
- a second layer (2) of a conductive material covering the first layer (1); the space charge zone (ZCE) being formed by the Schottky diode formed by the first layer (1) and the second layer (2), the porous region (PO) being formed in the first layer (1).

8. The measurement device according to the preceding claim, **characterised in that** the peripheral part (PP) comprises:
- a third layer (3') of a conductive material;
- a first layer (1') of a semiconductor material covering the third layer (3') and disposed in continuity with the first layer (1) of the central part (PC); and
- a second layer (2') of a conductive material covering the first layer (1) and disposed in continuity with the second layer (2) of the central part (PC);
the third layer (3') of a conductive material ensuring collection of a first type of charge carriers generated in the charge space zone (ZCE).

9. The measurement device according to claim 5, **characterised in that** the central part (PC) comprises:
- a first layer (1) of a semiconductor material doped with a first doping type;
- a second layer (2) of a semiconductor material doped with a second doping type opposite to the first doping type, said second layer (2) covering the first layer (1);
- a fourth layer (4) of a conductive material, said fourth layer (4) covering the second layer (2);
the space charge zone (ZCE) being formed by the PN diode formed by the first layer (1) and the second layer (2), the porous region (PO) being formed in the first layer (1).

10. The measurement device according to the preceding claim, **characterised in that** the peripheral part (PP) comprises:
- a third layer (3') of a conductive material;
- a first layer (1') of a semiconductor material doped with a first doping type covering the third layer (3') and disposed in continuity with the first layer (1) of the central part (PC); and
- a second layer (2') of a semiconductor material doped with a second doping type opposite to the first doping type covering the first layer (1'), said second layer (2') being disposed in continuity with the second layer (2) of the central part (PC);
- a fourth layer (4') of a conductive material, said fourth layer (4') covering the second layer (2'), said fourth layer (4') being disposed in continuity with the fourth layer (4) of the central part (PC);
the third layer (3') of a conductive material ensuring collection of a first type of charge carriers generated in the charge space zone (ZCE).

11. The measurement device according to claim 9, **characterised in that** the peripheral part (PP) comprises:
- a third layer (3') of a conductive material;
- a first layer (1') of a semiconductor material doped with a first doping type covering the third layer (3') and disposed in continuity with the first layer (1) of the central part (PC), the first layer (1) of the central part (PC) and of the peripheral part (PP) having the same doping level;
- a sixth layer (6) of a dielectric material covering the first layer (1);
- a fourth layer (4') of a conductive material covering the sixth layer (6); the fourth layer (4, 4') forming a step between the peripheral part (PP) and the central part (PC) covering a side surface of the sixth layer (6') so as to ensure continuity between the fourth layer (4) of the central part (PC) and the fourth layer (4') of the peripheral part (PP), the third layer (3') of a conductive material ensuring collection of a first type of charge carriers generated in the charge space zone (ZCE).

12. The device according to claim 5, **characterised in that** the central part (PC) comprises:
- a fifth layer (5) of a semiconductor material doped with a first doping type, at least part of the porous region (PO) being formed in the fifth layer (5);
- a first layer (1) of a semiconductor material doped with a first doping type, said first layer (1) covering the fifth layer (5), the doping level of the fifth layer (5) being higher than the doping level of the layer (1);
- a second layer (2) of a semiconductor material doped with a second doping type opposite to the first doping type, said second layer (2) covering the first layer (1);
- a fourth layer (4) of a conductive material, said fourth layer (4) covering the second layer (2);
the space charge zone (ZCE) being formed by the PIN diode formed by the fifth layer (5), the first layer (1) and the second layer (2).

13. The device according to the preceding claim, **characterised in that** the peripheral part (PP) comprises:
- a third layer (3') of a conductive material;
- a fifth layer (5') of a semiconductor material doped with a first doping type covering the third layer (3') and disposed in continuity with the fifth layer (5) of the central part (PC);
- a first layer (1') of a semiconductor material doped with a first doping type covering the fifth layer (5') and disposed in continuity with the first layer (1) of the central part (PC), the doping level of the fifth layer (5') being higher than the doping level of the first layer (1');
- a second layer (2') of a semiconductor material doped with a second doping type opposite to the first doping type covering the first layer (1'), said second layer (2') being disposed in continuity with the second layer (2) of the central part (PC);
- a fourth layer (4') of a conductive material, said fourth layer (4') covering the second layer (2'), said fourth layer (4') being disposed in continuity with the fourth layer (4) of the central part (PC);
the third layer (3') of a conductive material ensuring collection of a first type of charge carriers generated in the charge space zone (ZCE).

14. The device according to claim 12, **characterised in that** the peripheral part (PP) includes:
- a third layer (3') of a conductive material;
- a fifth layer (5') of a semiconductor material doped with a first doping type covering the third layer (3') and disposed in continuity with the fifth layer (5) of the central part (PC);
- a first layer (1') of a semiconductor material doped with a first doping type covering the fifth layer (3') and disposed in continuity with the first layer (1) of the central part (PC), the first layer (1) of the central part (PC) and the peripheral part (PP) having the same doping level, the doping level of the fifth layer (5') being higher than the doping level of the first layer (1');
- a sixth layer (6) of a dielectric material covering the first layer (1);
- a fourth layer (4') of a conductive material covering the sixth layer (6);
the fourth layer (4, 4') forming a step between the peripheral part (PP) and the central part (PC) covering a side surface of the sixth layer (6') so as to ensure continuity between the fourth layer (4) of the central part (PC) and the fourth layer (4') of the peripheral part (PP), the third layer (3') of a conductive material providing collection of a first type of charge carriers generated in the charge space zone (ZCE).

15. A Method (P100) for manufacturing a detector according to one of the preceding claims, from a semiconductor substrate (C5) doped with a first doping type comprising a front face and a rear face, the manufacturing method (P100) comprising:
- a step (PE1) of epitaxially growing, on the front face of the substrate (C5), a first layer (C1) of an intrinsic semiconductor material;
- a step (PE2) of epitaxially growing, on the front face of the substrate (C5), a second layer (C2) of a semiconductor material doped with a second doping type opposite to the first doping type;
- a step (PE3) of depositing, onto the rear face of the substrate, a third layer (C3) of a conductive material;
- a step (PE4) of performing photolithography on the third layer (C3) of a conductive material so as to provide at least one first opening within said layer (C3); and
- an etching step (PE5), at the rear face of the part of the substrate (C5) not covered in the third conductive layer (C3) so as to form a porous region (PO) in the substrate (C5) facing the first opening;
- a step (PE6) of depositing, onto the front face of the substrate (C5), a fourth layer (C4) of a conductive material.
